# FASCICULE DE BREVET EUROPEEN

(11) **EP 1 922 751 B1**
(45) Date de publication et mention de la délivrance du brevet: **17.08.2011**
(21) Numéro de dépôt: 06793255.8
(22) Date de dépôt: 06.09.2006
(51) Int. Cl.: H01L 21/762

(54) **PROCEDE DE FABRICATION D'UNE HETEROSTRUCTURE DE TYPE SEMI-CONDUCTEUR SUR ISOLANT**
VERFAHREN ZUM HERSTELLEN EINER HALBLEITER-AUF-ISOLATION-HETEROSTRUKTUR
METHOD FOR MAKING A SEMICONDUCTOR-ON-INSULATION HETEROSTRUCTURE

(30) Priorité: 08.09.2005 FR 0509168
(43) Date de publication de la demande: 21.05.2008
(73) Titulaire: S.O.I.TEC Silicon on Insulator Technologies S.A., 38190 Bernin (FR)
(72) Inventeur: HEBRAS, Xavier, F-38100 Grenoble (FR)
(74) Mandataire: Bomer, Françoise Marie
(86) Numéro de dépôt international: PCT/EP2006/066046
(87) Numéro de publication internationale: WO 2007/028800

(56) Documents cités:
- EP-A- 1 174 926
- US-A- 5 953 622
- US-A1- 2004 171 196
- US-B1- 6 696 352

## Description

La présente invention concerne un procédé de fabrication d'un substrat de type "semi-conducteur sur isolant", connu sous l'acronyme "SeOI", d'après la terminologie anglaise de "*Semiconductor On Insulator*".

Un tel substrat ou hétérostructure est utilisé en particulier dans les domaines de l'optique, l'électronique et l'optoélectronique.

Un substrat de type "SeOI" comprend généralement au moins une couche d'isolant, intercalée entre deux couches de matériau semi-conducteur.

Dans la suite de la description et des revendications, le terme "isolant" désigne un matériau électriquement isolant, présentant éventuellement une permittivité électrique élevée.

Les substrats SeOI sont fabriqués selon un procédé comprenant, par exemple, les étapes suivantes :
- formation ou dépôt d'une couche d'isolant sur un premier substrat, dit "donneur", de sorte qu'il existe entre eux une interface dite de « liaison »,
- implantation d'espèces atomiques à l'intérieur dudit substrat donneur, par un procédé connu selon la nomination commerciale "Smart Cut™, de façon à y former une zone de fragilisation,
- collage par adhésion moléculaire d'un second substrat, dit "receveur", sur la surface libre de l'isolant, et
- détachement de la partie arrière dudit substrat donneur, le long de la zone de fragilisation.

On obtient ainsi une hétérostructure comprenant successivement un support, une couche d'isolant et une couche supérieure active issue du substrat donneur.

Dans le domaine de la microélectronique, la qualité de surface de la couche active de matériau semi-conducteur est d'une très grande importance. Plus précisément, la rugosité, ainsi que l'absence de défauts à la surface de cette couche active sont des paramètres qui doivent être optimisés, pour que les futurs composants qui seront réalisés à partir de ces hétérostructures soient d'une qualité optimale.

Or, différents types de défauts de surface peuvent apparaître après le transfert de la couche active, sur le substrat receveur. Ces défauts sont notamment :
- les zones non transférées (connues sous l'abréviation ZNT),
- les cloques,
- les vides, connus sous la terminologie anglaise de "*voids*",
- les "cloques à bords orientés suivant un plan cristallin", connues de l'homme du métier sous l'acronyme "COV", d'après la terminologie anglaise de "*Crystal Orientated Voids*".

Tous ces défauts sont dus à un mauvais transfert, à la présence de défauts sous-jacents dans les diverses couches de l'hétérostructure, à la qualité du collage au niveau de l'interface de collage ou tout simplement, aux procédés mis en oeuvre pour fabriquer de telles hétérostructures, tels que l'implantation d'espèces atomiques ou le traitement thermique, par exemple.

Les défauts présents au niveau des interfaces de collage ou des interfaces de liaison vont devenir des lieux de piégeage de gaz, lors des différentes étapes du procédé et vont ainsi gonfler et former des cloques de type COV ou des vides.

Ainsi, par exemple, dans le cas d'une hétérostructure comprenant successivement un substrat support en silicium, recouvert d'une couche d'oxyde thermique, puis d'une couche d'oxyde TEOS obtenue par dépôt LPCVD, et enfin d'une couche de germanium, les éléments gazeux peuvent avoir plusieurs origines. L'expression « LPCVD TEOS » désigne un oxyde de silicium (SiO₂) obtenu par un dépôt chimique en phase vapeur à basse pression, à partir d'un précurseur de type tétraéthylorthosilicate (TEOS).

Ces éléments gazeux peuvent provenir notamment de :
- de l'hydrogène ou de l'hélium amené lors de l'étape d'implantation d'espèces atomiques visant à former la zone de fragilisation, la quantité de ces éléments gazeux dépendant du type d'implanteur utilisé et des conditions d'implantation (dose et énergie),
- de la désorption des molécules d'eau (H₂O), présentes à l'interface de collage entre l'oxyde thermique et l'oxyde TEOS,
- de l'oxyde TEOS, si la densification de ce dernier n'a pas été suffisante, à cause de la diffusion de composés carbonés.

De plus, on notera que plus l'épaisseur de la couche utile est faible, plus le nombre de défauts est important. En effet, lorsque la couche active est épaisse, les défauts du type cloques ou vides sont généralement retenus dans l'épaisseur de la couche active, et de ce fait, apparaissent moins à sa surface.

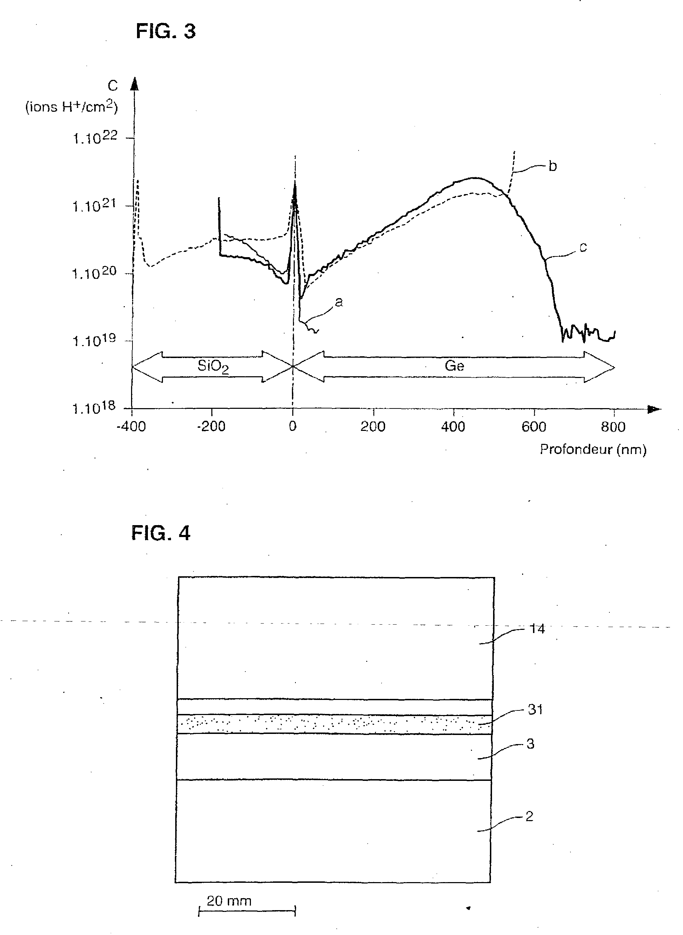

A titre d'exemple illustratif de ces problèmes de défauts, on peut se reporter à la figure 3 jointe.

Celle-ci est un graphique représentant la concentration **C** en ions H⁺/cm² dans un substrat composite, en fonction de la profondeur en nanomètres, les résultats ayant été obtenus par spectroscopie de masse d'ions secondaires (SIMS).

Plus précisément, ce substrat composite est le résultat d'un collage entre un substrat support (Si) ayant subit une oxydation thermique, et un substrat donneur de Ge sur lequel a été déposé une couche de SiO₂. L'interface de collage se fait donc entre deux oxydes, l'un appartenant au substrat support et l'autre appartenant au substrat donneur. Sur le graphe 3, l'interface de collage entre les deux couches de SiO₂ est située à -200 nm. Le substrat support n'est pas représenté sur la figure 3, seule son interface de liaison avec la couche de SiO₂ l'est et cette interface se situe à -400 nm.

La courbe **a** en trait plein représente les résultats obtenus dans le substrat donneur en germanium (Ge) recouvert de SiO₂, avant le collage des deux substrats et avant l'implantation d'espèces atomiques Smart Cut™ en vue de la formation de la zone de fragilisation à l'intérieur de la couche de germanium. Les ions H⁺ se trouvent principalement à l'interface de liaison entre la première couche de SiO₂ et la couche de germanium.

La courbe **c** en trait gras représente les résultats obtenus dans le même substrat après l'implantation permettant la formation de la zone de fragilisation et avant le collage avec la seconde couche de SiO₂. On notera que le trait vertical à -200 nm correspond à un artéfact. Les valeurs ne commencent que vers -200 nm car ceci correspond à l'implantation réalisée avant de coller la seconde couche de SiO₂. Dans le cas particulier du germanium, le détachement ne se fait pas au niveau de l'implantation maximale, mais juste un peu après (env. 550 nm), ce qui explique l'allure de la courbe **b** ci-après.

La courbe **b** en traits pointillés représente les résultats obtenus après le collage des deux couches de SiO₂ et après le détachement et le transfert de la couche active de germanium. La répartition des espèces hydrogène montre une accumulation au niveau des interfaces de liaison SiO₂/Ge et SiO₂/substrat support. Un tout petit pic au niveau de la couche de SiO₂ apparaît à -200 nm : il correspond à l'interface de collage des deux couches de SiO₂.

On constate une nette augmentation de la quantité de gaz dans la couche d'isolant (SiO₂) après l'étape de détachement et de report de la couche active de germanium. Cette augmentation est à l'origine des défauts visibles après transfert sur la face supérieure de la couche de germanium reportée.

On connaît déjà d'après le document US-2002/0190269, un procédé de fabrication d'une hétérostructure comprenant une couche de germanium sur du silicium, ce procédé ayant pour but de réduire la formation de bulles au niveau de l'interface de collage. Plus précisément, cette hétérostructure est obtenue par implantation d'hydrogène dans un substrat donneur en germanium pour y former une zone de fragilisation, puis collage sur un substrat receveur en silicium, et enfin traitement thermique pour détacher la partie arrière du substrat en germanium.

Dans un mode particulier de réalisation, l'auteur suggère de disposer une couche dénommée "anti-bulles" de silicium amorphe, sur le substrat en germanium, avant le collage, afin de rendre l'interface de collage hydrophile et de réduire ainsi la formation de bulles d'hydrogène, lorsque le substrat en germanium est collé au substrat en silicium.

Selon une autre variante de réalisation, il est suggéré d'améliorer la rugosité de la couche de germanium transférée, en déposant sur celle-ci, une couche tampon de germanium, formée par épitaxie.

Ces deux solutions ont pour but d'améliorer la qualité de l'interface de collage entre les deux substrats, toutefois, elles nécessitent l'ajout d'une couche supplémentaire, ce qui complique le procédé.

On connaît également d'après le document US 6 696 352 un procédé de fabrication d'un substrat multicouches comportant une couche cristalline mince et une couche sacrificielle. Dans ce procédé, il est proposé de former une zone de fragilisation à l'intérieur d'un substrat source, afin de pouvoir reporter ultérieurement une partie de ce substrat, sur un substrat receveur.

Pour ce faire, une couche de piégeage d'ions H⁺ est formée par implantation d'espèces atomiques à l'intérieur du substrat donneur. Ce dernier est ensuite collé sur le substrat receveur, à l'aide d'un adhésif apte à libérer des ions H⁺ par chauffage. Après traitement thermique de ce substrat, les ions H⁺ contenus dans l'adhésif migrent vers la couche de piégeage et celle-ci se transforme après recuit en une zone de fragilisation.

Toutefois, ce document ne s'applique pas à la formation d'un substrat SeOI, et ne suggère pas de réaliser une couche de piégeage dans une couche d'isolant, cette couche de piégeage servant à retenir les diverses espèces gazeuses présentes au niveau des différents interfaces du substrat SeOI.

On connaît enfin d'après le document US-2004/0171916, un procédé de fabrication d'un substrat de type SOI, qui, de façon similaire à ce qui a été décrit

Document EP-A-1 174 926 concerne un procédé de fabrication d'une structure multicouches, qui comprend au moins deux couches d'isolant intercalées entre trois couches de matériau semi-conducteur.

Le procédé utilisé met en oeuvre une étape d'implantation d'atomes d'oxygène à l'intérieur d'un substrat en matériau semi-conducteur, de façon à y définir une couche d'ions oxygène implantés, puis une étape de transformation de cette couche implantée en une couche isolante d'oxyde, par traitement thermique.

ci-dessus, propose de former une couche de piégeage d'ions dans un substrat donneur, en vue de la transformer ultérieurement en zone de fragilisation.

La couche de piégeage conforme à l'invention s'en distingue de par sa position et son utilité. Elle n'est en effet pas destinée à devenir une zone de fragilisation utilisée lors d'un report de couche.

L'invention a pour but d'éviter la formation des défauts à la surface de la couche active transférée, plus précisément des défauts dus à l'agglomération d'éléments gazeux au niveau des différentes interfaces de collage et/ou de liaison.

L'invention a également pour but d'éviter le recours au dépôt de couches intermédiaires (couches amorphes ou couches tampons), déposées ou intercalées entre la couche d'isolant et la couche active, comme cela est le cas d'après les procédés connus de l'état de la technique. En effet, de telles couches sont susceptibles de modifier les propriétés électriques de la structure finale.

A cet effet, l'invention concerne un procédé de fabrication d'une hétérostructure du type "semi-conducteur sur isolant", comprenant au moins une couche d'isolant, intercalée entre un substrat, dit "receveur", et une couche, dite "active", issue d'un substrat, dit "donneur", au moins l'une desdites couches d'isolant comprenant une couche, dite "de piégeage", apte à retenir les espèces gazeuses éventuellement présentes au niveau des différentes interfaces de l'hétérostructure et à limiter la formation de défauts à la surface de la couche active de ladite hétérostructure, ce procédé comprenant les étapes consistant à :
- former ou déposer au moins une couche d'isolant sur au moins l'un des deux substrats donneur et receveur, ces deux substrats étant réalisés en matériau semi-conducteur,
- coller ledit substrat donneur et ledit substrat receveur, par adhésion moléculaire, de façon que la ou les couche(s) d'isolant soi(ent) intercalée(s) entre eux et qu'il existe entre l'un des deux substrats et l'une des couches d'isolant ou entre les deux couches d'isolant, une interface de collage,
- retirer une partie, dite "reste", du substrat donneur, de façon à ne conserver que ladite couche active et à obtenir ladite hétérostructure.

Ce procédé est remarquable en ce qu'avant le collage, on procède à la formation de ladite couche de piégeage en implantant au moins une catégorie d'espèces atomiques à l'intérieur d'au moins l'une des couches d'isolant, cette catégorie d'espèces atomiques étant choisie de façon à être soit identique à l'une des espèces atomiques constituant la couche d'isolant dans laquelle ces espèces sont implantées, soit à appartenir à la même colonne du tableau de la classification périodique de Mendeleïev que l'une des espèces atomiques constituant la couche d'isolant dans laquelle elles sont implantées.

Selon d'autres caractéristiques avantageuses et non limitatives de l'invention, prises seules ou en combinaison :
- après la formation de la couche de piégeage, on procède à une étape de recuit de la couche d'isolant contenant cette couche de piégeage, à une température d'au moins 350°C, pendant au moins 30 minutes ;
- les paramètres de l'implantation sont choisis de façon à former ladite couche de piégeage, soit à proximité de ladite interface de collage, de préférence à une distance comprise entre 2 et 10 nanomètres de l'interface de collage, soit à proximité d'une interface de liaison entre la couche d'isolant et l'un ou l'autre des deux substrats ;
- la couche de piégeage est constituée d'une couche bidimensionnelle de nanocavités ou de nanoparticules ;
- l'isolant peut être un oxyde, par exemple du dioxyde de silicium (SiO₂) et les espèces implantées sont alors choisies parmi les atomes de silicium, de germanium ou d'oxygène ;
- l'isolant peut être un nitrure, par exemple du nitrure de silicium (Si₃N₄) et les espèces implantées sont alors choisies parmi les atomes de silicium, de germanium ou d'azote ;
- le retrait de la partie arrière est effectué par polissage mécanico-chimique ;
- avant le collage, on forme une zone de fragilisation à l'intérieur du substrat source, cette zone de fragilisation délimitant la couche active, du reste dudit substrat destiné à être retiré ; cette zone de fragilisation pouvant être formée par implantation d'espèces atomiques ;

L'invention concerne également une hétérostructure du type "semi-conducteur sur isolant", comprenant au moins une couche d'isolant, intercalée entre un substrat, dit "receveur", en matériau semi-conducteur, et une couche, dite "active", en matériau semi-conducteur.

Conformément à l'invention, au moins l'une desdites couches d'isolant comprend une couche de piégeage constituée d'une couche bidimensionnelle de nanocavités ou de nanoparticules, cette couche de piégeage étant apte à retenir les espèces gazeuses éventuellement présentes au niveau des différentes interfaces de l'hétérostructure et à limiter la formation de défauts à la surface de la couche active de ladite hétérostructure.

D'autres caractéristiques de l'invention apparaîtront de la description qui va maintenant être faite, en référence aux dessins annexés, qui en représentent, à titre indicatif mais non limitatif, des modes de réalisations possibles.

Sur ces dessins :
- les figures 1A à 1E sont des schémas représentant les différentes étapes successives du procédé de fabrication conforme à un premier mode de réalisation de l'invention,
- les figures 2A à 2F sont des schémas représentant les différentes étapes successives du procédé de fabrication conforme à un second mode de réalisation de l'invention,
- la figure 3 est un graphique représentant la concentration C en ions H⁺/cm², en fonction de la profondeur exprimé e en nanomètres, dans un substrat composite résultant d'un collage entre un substrat support (Si) ayant subit une oxydation thermique, et un substrat donneur de Ge sur lequel à été déposé une couche de SiO₂. Les résultats ont été obtenus par spectroscopie de masse d'ions secondaires (SIMS),
- la figure 4 est un dessin réalisé à partir d'une photographie d'une coupe d'une partie d'un substrat support oxydé avant collage SeOI, incluant une couche de piégeage formée dans la couche de SiO₂, cette photographie ayant été obtenue par microscopie électronique à transmission (TEM).

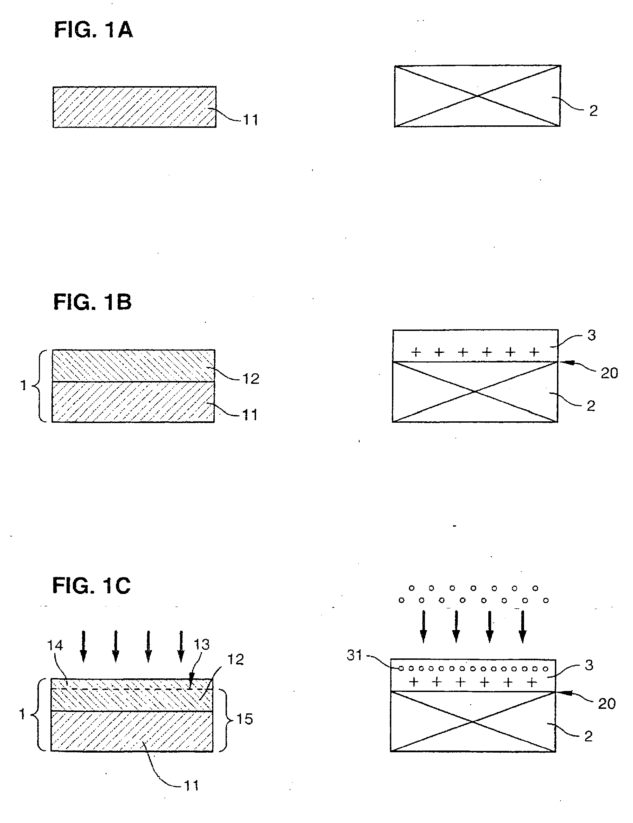

Un premier mode de réalisation de l'invention va être maintenant être décrit en faisant référence aux figures 1A à 1E.

Comme cela apparaît mieux sur les figures 1A et 1B, on utilise un substrat 1, dit "donneur", car c'est de ce substrat qu'est issue la couche active dans le futur substrat composite ou hétérostructure obtenu en fin de procédé.

Ce substrat donneur 1 peut être monocouche ou multicouche, par exemple à deux couches, comme représenté sur la figure 1B. Dans ce cas, il se compose d'une couche primaire 11, recouverte d'une couche secondaire 12. La couche secondaire est par exemple déposée par épitaxie sur la couche primaire.

Par ailleurs, on utilise un substrat support ou receveur 2, sur lequel on dépose ou dans lequel on forme une couche d'isolant 3, comme représenté sur la figure 1B, et comme cela sera décrit plus en détail ultérieurement.

Entre la couche d'isolant 3 et le substrat receveur 2 existe une interface de liaison référencée 20.

Comme représenté sur la figure 1C, on procède ensuite à une implantation d'espèces atomiques à l'intérieur du substrat donneur 1, par exemple à l'intérieur de la couche secondaire 12, de façon à y former une zone de fragilisation 13. Cette zone 13 délimite une couche supérieure active 14, du reste 15 du substrat.

Dans la variante du substrat à deux couches, représentée sur la figure 1C, le reste 15 comprend une partie de la couche secondaire 12 et la couche primaire 11.

Par ailleurs, conformément à l'invention, on procède à une implantation d'espèces atomiques à l'intérieur de la couche d'isolant 3, en vue d'y former une couche de piégeage 31.

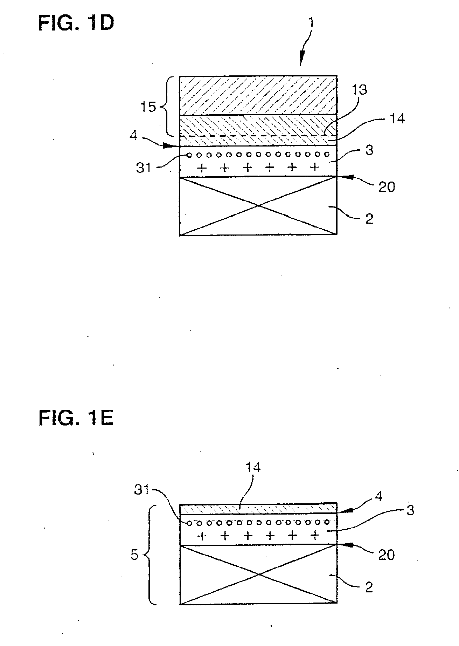

Comme on peut le voir sur la figure 1D, on procède ensuite au collage par adhésion moléculaire des deux substrats donneur 1 et receveur 2, par mise en contact intime de la couche active 14 avec la couche d'isolant 3. L'interface de collage porte la référence numérique 4.

Comme représenté sur la figure 1E, on procède ensuite au retrait de la partie arrière 15.

Dans le cas particulier, où il existe une zone de fragilisation 13, ce retrait correspond au détachement de la partie arrière ou reste 15 du substrat. Ce détachement est effectué par application de contraintes d'origine mécanique, chimique ou électrique, au niveau de la zone de fragilisation 13.

On obtient l'hétérostructure référencée 5.

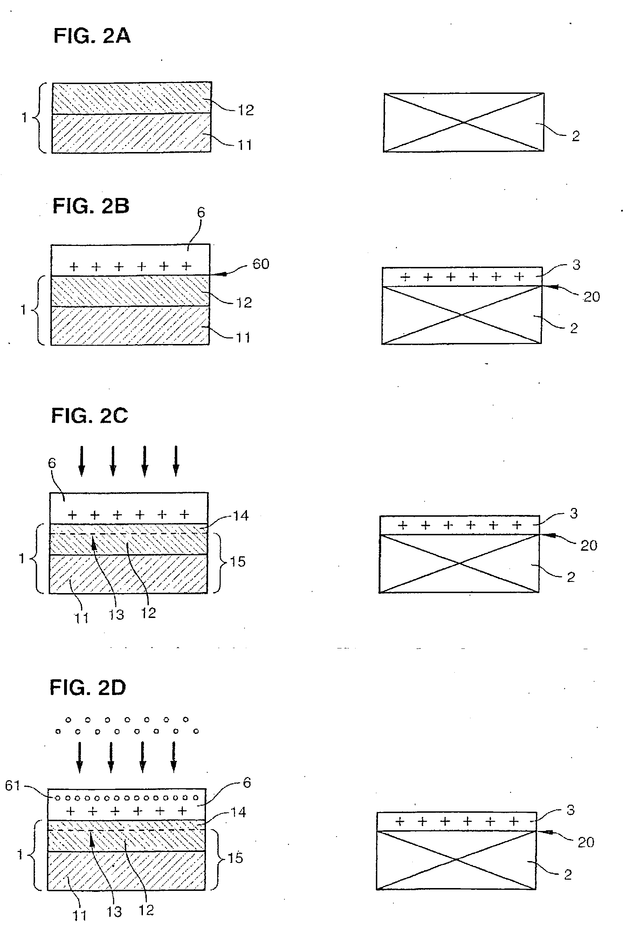

Les figures 2A à 2F illustrent une variante de réalisation de procédé qui vient d'être décrit.

Les mêmes éléments portent les mêmes références numériques.

Cette variante diffère du procédé précédent, d'une part en ce que l'on dépose ou l'on forme une couche d'isolant 6 sur le substrat source 1, avant l'étape d'implantation d'espèces atomiques permettant la formation de la zone de fragilisation 13 à l'intérieur de ce substrat, et d'autre part, en ce que la couche de piégeage, qui porte ici la référence numérique 61, est formée par implantation d'espèces atomiques à l'intérieur de la couche d'isolant 6, cette dernière reposant sur ledit substrat source.

Il est possible de réaliser successivement, la formation de la zone de fragilisation 13, puis celle de la couche de piégeage 61, comme cela est d'ailleurs illustré sur les figures 2C et 2D.

Toutefois, de préférence, on effectue d'abord l'implantation permettant la formation de la zone de piégeage 61, avant celle permettant la formation de la zone de fragilisation 13. En précédant ainsi, les éléments contaminants lourds, qui sont éventuellement présents lors de l'implantation destinée à former la zone de fragilisation 13, se trouvent retenus dans la couche de piégeage 61, tandis que les éléments plus légers, tels que les ions H⁺ par exemple, traversent la couche d'isolant 6 sans y être retenus et vont former la zone de fragilisation 13.

On notera qu'il existe entre la couche d'isolant 6 et le substrat source 1, une interface de liaison 60.

Dans le mode de réalisation représenté sur la figure 2D, la couche d'isolant 3 ne subit pas le même traitement. Toutefois, il serait également possible d'y former une couche de piégeage 31. Dans ce cas, le substrat composite final obtenu en comporterait deux.

Il serait également possible de ne pas former de couche d'isolant 3 sur le substrat receveur 2, puisqu'il y a une couche d'isolant 6 sur le substrat donneur 1.

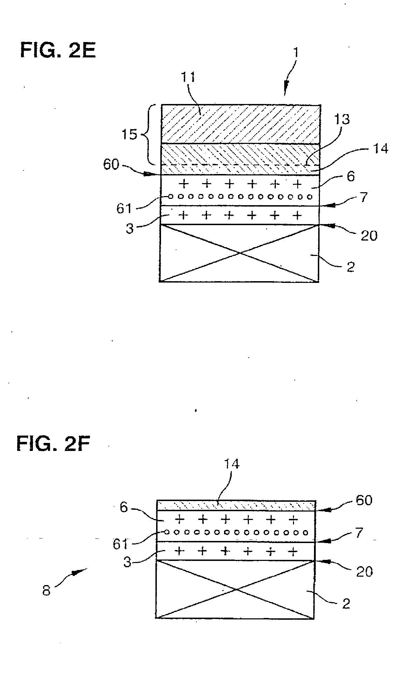

Enfin, comme on peut le voir sur la figure 2E, on procède au collage par adhésion moléculaire des deux substrats 1 et 2, de sorte qu'il existe entre eux une interface de collage 7.

Après détachement du reste 15 du substrat source 1, on obtient l'hétérostructure 8 représentée sur la figure 2F.

Cette hétérostructure 8 comprend deux couches d'isolant 3, 6, intercalées entre deux couches de matériau semi-conducteur respectivement 14 et 2.

Dans les deux modes de réalisation qui viennent d'être décrits, le détachement du reste 15 du substrat source 1 est effectué après formation d'une zone de fragilisation par implantation d'espèces atomiques.

Toutefois, cette étape d'implantation pourrait également être supprimée, le reste 15 étant alors retiré par une étape de polissage mécanico-chimique, connu de l'homme du métier sous la terminologie de polissage "CMP".

La nature et les caractéristiques des matériaux constituant les substrats source et receveur, et la couche d'isolant vont être maintenant décrits plus en détails.

Les substrats donneur 1 et receveur 2 sont constitués au moins en partie par des matériaux semi-conducteurs, notamment ceux couramment utilisés dans le domaine de l'électronique. Il s'agit, par exemple, du silicium (Si), du germanium (Ge), du nitrure de Gallium (GaN), de l'arséniure de gallium (AsGa) et du silicium germanium (SiGe).

Les couches d'isolant 3, 6 sont choisies de préférence parmi les oxydes, tels que l'oxyde silicium (SiO₂). Il peut également s'agir de nitrure, par exemple du nitrure de silicium (Si₃N₄) ou d'oxynitrure, par exemple l'oxynitrure de Germanium (GeₓO_{y}N_{z}).

Il est également possible d'utiliser des matériaux diélectriques à forte permetivité ("*high k*" selon la terminologie anglaise), tels que par exemple du dioxyde de hafnium (HfO₂), de l'alumine (Al₂O₃), de l'oxyde de zirconium (ZrO₂), du pentoxyde de tantale (Ta₂O₅), du dioxyde de titane (TiO₂), leurs nitrures et leurs siliciures.

Lorsque les couches d'isolant 3 ou 6 sont constituées par un oxyde, elles peuvent être obtenues par oxydation thermique du substrat source 1 ou du support 2 sur lequel elles doivent être formées.

Ces couches d'isolant 3 ou 6 peuvent également être obtenues par dépôt, par exemple dépôt chimique en phase vapeur.

A titre d'exemple, pour du dioxyde de silicium (SiO₂), il est possible d'utiliser le dépôt chimique en phase vapeur à basse pression (LPCVD) ou un procédé de dépôt en couches atomiques, connu sous l'acronyme "ALD" ("*Atomic layer deposition*").

Dans le cas du dépôt d'une couche de SiO₂, il est également possible de procéder au dépôt par LPCVD, à partir d'un précurseur de type tétraéthylorthosilicate (TEOS).

L'implantation d'espèces atomiques permettant la formation d'une zone de fragilisation à l'intérieur du substrat source peut être effectuée, par exemple, par le procédé connu sous la dénomination commerciale "Smart Cut™".

Pour de plus amples détails sur ce procédé, on pourra se reporter au document "Silicium on insulator technology" ; matérials to VLSI, 2ème édition, par JP Collinge, Kluwer academic publishers, pp 50-51.

Le terme "implantation d'espèces atomiques" désigne couramment tout type de traitement, susceptible d'introduire des espèces atomiques ou ioniques à l'intérieur du substrat donneur implanté, avec une concentration maximale des espèces situées à une profondeur prédéterminée depuis la surface traitée.

L'implantation d'espèces atomiques à l'intérieur de la couche d'isolant 3, 6 visant à y former une couche de piégeage 31, respectivement 61, va maintenant être décrite plus en détails.

La couche 31, 61 a pour but de piéger les espèces gazeuses diffusantes.

La formation de la couche de piégeage consiste à implanter au moins une catégorie d'espèces atomiques à l'intérieur de la couche d'isolant, ces espèces atomiques étant choisies de façon à être soit identiques, soit "isoélectriques", à l'une des espèces atomiques constituant ledit isolant.

Plus précisément, il est possible d'implanter une seule catégorie d'espèces atomiques ou successivement plusieurs.

Cette étape permet soit de sursaturer l'isolant avec au moins une catégorie des atomes ou espèces atomiques contenus dans celui-ci, soit d'y introduire une espèce atomique "isoélectrique". Par «espèce atomique isoélectrique », on désigne toute espèce atomique appartenant à la même colonne du tableau de la classification périodique de Mendeleïev que l'une des espèces atomiques constituant ledit isolant. Toutefois, le choix de l'espèce atomique dans cette colonne dépendra de sa réactivité chimique vis-à-vis des catégories d'espèces atomiques constituant l'isolant.

A titre d'exemple purement illustratif, dans une couche d'oxyde de silicium (SiO₂), on peut implanter de l'oxygène, du silicium et/ou du germanium (le germanium appartenant à la colonne 4a du tableau périodique comme le silicium). Dans une couche de nitrure de silicium (Si₃N₄), on peut implanter de l'azote, du silicium et/ou du germanium.

La couche de piégeage obtenue peut être constituée de deux types de pièges suivant la nature de l'élément implanté, à savoir :
- des nano-cavités (en anglais "*voids*") dans le cas d'une implantation d'atomes tels que l'oxygène ou l'azote,
- des nanoparticules, pour une implantation de silicium ou de germanium.

Les paramètres d'implantation sur lesquels on peut agir sont d'une part, l'énergie d'implantation qui permet de faire varier la profondeur à laquelle sera formée la couche de piégeage, et d'autre part, la dose d'implantation qui permet de modifier la taille des agglomérats d'atomes et la densité de nanoparticules ou de nano-cavités formées.

A titre d'exemple, en implantant du silicium dans du SiO₂, avec une énergie d'implantation comprise entre 0,65 keV et 3 keV et des doses d'implantation comprises entre 5.10¹⁵ et 2.10¹⁶ Si⁺/cm², on obtient une couche de piégeage située à une profondeur comprise entre -4 nm et -6 nm, sous la surface libre du SiO₂, cette couche de piégeage présentant une épaisseur comprise entre 2 et 3 nm et une densité surfacique de nanoparticules très forte, supérieure à 1.10¹⁵ cm⁻².

La couche de piégeage peut être toutefois formée à n'importe quelle profondeur de la couche isolante.

Selon une première variante, elle est formée le plus près possible de l'interface de collage qui est à l'origine de l'accumulation des gaz. Ainsi, elle agit comme une pompe chimique. Elle est de plus beaucoup plus efficace dans ce cas.

La couche de piégeage peut également être formée le plus près possible de l'interface de liaison entre la couche d'isolant et le substrat. Ceci est particulièrement intéressant dans le cas d'un oxyde déposé, où l'interface de liaison peut être une zone importante d'accumulation d'espèces atomiques gazeuses. La zone de piégeage va alors aider à diminuer la concentration de gaz accumulé à l'interface de liaison.

Lorsque l'on a deux couches d'isolant 3 et 6, comme dans le mode de réalisation représenté sur la figure 2, il peut également être intéressant de réaliser une couche piégeage dans chacune des deux couches d'isolant. De préférence, ces couches de piégeage seront alors formées à des profondeurs différentes, de façon que l'une soit proche d'une interface de liaison et que l'autre soit proche de l'interface de collage.

Enfin, il peut être avantageux, une fois l'hétérostructure 5 ou 8 formée, de procéder à un recuit thermique. Celui-ci a pour but d'une part de renforcer le collage et d'autre part, de faire évoluer la couche de pièges. Toutefois, ce procédé de recuit est limité par le bilan thermique maximal applicable, comme cela sera expliqué ultérieurement.

Plusieurs phénomènes physico-chimiques vont entraîner la formation des pièges, puis la capture des espèces gazeuses.

Dans le cas où les pièges sont des nanoparticules, celles-ci vont être formées dans l'isolant, au fur et à mesure de l'implantation, puis certaines vont coalescer partiellement jusqu'à former de petits agglomérats de particules.

Cette coalescence va aboutir à la formation d'une couche bidimensionnelle de nanoparticules et de petits agglomérats qui vont piéger les espèces gazeuses, notamment l'hydrogène, par effet mécanique et par effet chimique.

Le terme "coalescence" désigne dans ce cas, la répartition et la réorganisation des nanoparticules dans le même plan que l'implantation.

La couche de piégeage est bidimensionnelle parce qu'elle s'étend sur toute la surface de la structure, à une profondeur contrôlée par l'énergie d'implantation. Elle va piéger les espèces diffusantes en les empêchant ainsi d'atteindre les interfaces de collage ou de liaison proches.

L'effet chimique du piégeage correspond à la formation de liaisons entre les éléments présents. Ainsi, par exemple les atomes de silicium ou de germanium introduits dans une couche de SiO₂ formeront des liaisons Si-H ou Ge-H, lorsque de l'hydrogène sera libéré à proximité. La réaction chimique de piégeage de l'hydrogène est particulièrement favorisée dans le cas d'une implantation de germanium, car l'énergie de formation de la liaison Ge-H est beaucoup plus petite.

L'effet mécanique du piégeage correspond à l'établissement d'un gradient de concentration entre l'interface de collage ou de liaison et la zone de piégeage. La coalescence des nanoparticules permet d'augmenter la densité des pièges. La concentration d'atomes emprisonnés sur ces pièges s'accroît. Il s'installe alors un gradient d'atomes de gaz libres entre l'interface de collage ou de liaison et la couche de piégeage. On augmente alors le phénomène de diffusion des espèces gazeuses vers les pièges jusqu'à saturation de ces derniers.

Enfin, on notera que même lorsqu'un recuit est réalisé après la formation de la couche de piégeage, (voir figures 1C et 2D), les agglomérats de particules obtenus restent petits. En effet, ce recuit doit être effectué à une température inférieure à celle de l'étape ultérieure de détachement, réalisée après le collage, (voir respectivement les figures 1E et 2F).

Il y aura donc une multitude de petits agglomérats de quelques angströms qui commencent à coalescer sous forme de nanoparticules. Le piégeage est principalement assuré par ces petits agglomérats, produits à faible bilan thermique.

Dans le cas, où les pièges sont des nano-cavités, les particules de gaz libres viennent s'y piéger. Les espèces vont s'accumuler dans ces nano-réservoirs enfouis dans l'isolant. Un gradient de concentration s'installe entre les espèces gazeuses libres et les espèces gazeuses retenues sur les défauts créés dans l'oxyde. Ce gradient de concentration sera la force motrice du piégeage jusqu'à saturation des nano-cavités.

Plusieurs exemples de réalisation vont maintenant être décrits plus en détails.

### Exemple 1 :

On a préparé un substrat donneur en faisant croître par épitaxie une couche de germanium, sur du silicium. On a alors effectué à l'intérieur du germanium, une implantation d'hydrogène et/ou d'hélium, afin d'y créer une zone de fragilisation.

On a préparé par ailleurs un substrat récepteur en silicium en y déposant une couche isolante d'oxyde de silicium (SiO₂) de 250 à 300 nm.

On a ensuite procédé à l'implantation de silicium, dans la couche de SiO₂, pour y créer une couche bidimensionnelle de piégeage. Cette implantation s'effectuait à une énergie de 0,5 à 5 keV, pour une dose de 5.10¹⁵ à 5.10¹⁶ d'ions Si⁺/cm².

Ceci a conduit à la formation d'une couche de nanoparticules située entre 1,5 nm et 4 nm (nanomètres), sous la surface de la couche de SiO₂, et dont l'épaisseur est comprise entre 2 et 3 nm.

Le collage et le détachement sont effectués comme décrit précédemment en liaison avec les figures 1 et 2.

### Exemple 2 :

La figure 4 est un dessin réalisé à partir d'une photo obtenue par microscopie électronique à transmission (TEM), qui représente une couche de piégeage formée dans une couche de SiO₂, par implantation de silicium avec une énergie de 1 keV et une dose de 1.10¹⁶ Si⁺/cm². Cette couche de piégeage 31 apparaît comme une ligne plus sombre au milieu de l'oxyde 3.

Par ailleurs, des essais ont été effectués pour déterminer les gammes d'énergie et de dose d'implantation à utiliser pour réaliser la couche de piégeage, lorsque l'isolant est respectivement du dioxyde de silicium (SiO₂) ou du nitrure de silicium (Si₃N₄). Les valeurs sont données ci-après.

Lorsque l'isolant est du dioxyde de silicium (SiO₂), les espèces implantées sont choisies parmi les atomes de silicium, germanium et d'oxygène.

Dans ce cas, on peut implanter au choix, soit uniquement l'une des catégories d'espèces atomiques mentionnées ci-dessous, soit successivement plusieurs d'entre elles :
- des atomes de silicium avec une énergie d'implantation comprise entre 0,5 et 5 keV et une dose d'implantation comprise entre 5.10¹⁵ et 5. 10¹⁶ Si⁺/cm². Dans ces conditions, la couche de nanoparticules sera située entre 15 nm et 40 nm sous l'interface de collage. L'augmentation de la dose d'implantation permet d'augmenter la densité surfacique des pièges et donc de moduler la quantité totale d'atomes de gaz emprisonnés sur ces pièges.
- des atomes de germanium avec une énergie d'implantation comprise entre 0,7 et 10 keV et une dose d'implantation comprise entre 5. 10¹⁵ et 1. 10¹⁷ Ge⁺/cm². Le germanium étant plus lourd, la gamme d'énergie d'implantation est plus large pour positionner le plan de nano-particules dans la même gamme de profondeur.
- des atomes d'oxygène avec une énergie d'implantation comprise entre 0,5 et 3 keV et une dose d'implantation comprise entre 1.10¹⁵ et 1.10¹⁷ O⁺/cm². Pour positionner la zone de piégeage à la même profondeur que précédemment, la fenêtre d'énergie d'implantation est ici réduite par rapport à l'implantation de silicium car l'oxygène est plus léger.

Lorsque l'isolant est du nitrure de silicium (Si₃N₄), les espèces implantées sont choisies parmi les atomes de silicium, de germanium ou d'azote.

Dans ce cas, on peut implanter au choix, soit uniquement l'une des catégories d'espèces atomiques mentionnées ci-dessous, soit successivement plusieurs d'entre elles :
- des atomes de silicium avec une énergie d'implantation comprise entre 0,5 et 5 keV et une dose d'implantation comprise entre 5. 10¹⁵ et 5.10¹⁶ Si⁺/cm² ;
- des atomes de germanium avec une énergie d'implantation comprise entre 0,7 et 10 keV et une dose d'implantation comprise entre 5.10¹⁵ et 1.10¹⁷ Ge⁺/cm² ;
- des atomes d'azote avec une énergie d'implantation comprise entre 0,5 et 3 keV et une dose d'implantation comprise entre 1.10¹⁵ et 1.10¹⁷ N⁺/cm².

Le procédé de fabrication de SeOI conforme à l'invention permet de s'affranchir de tous les défauts dus à l'accumulation de gaz aux interfaces de collage ou de liaison d'une hétérostructure.

Le procédé conforme à l'invention est applicable à la fabrication de substrats semi-conducteurs sur isolant, avec tout type de matériau semi-conducteur, puisque la couche de piégeage est formée dans l'isolant. Les avantages seront bien entendu plus marqués dans le cas du GeOI, car d'après les profils SIMS, on observe une forte quantité d'hydrogène présent dans l'oxyde.

## Revendications

1. Procédé de fabrication d'une hétérostructure (5, 8) du type "semi-conducteur sur isolant", comprenant au moins une couche d'isolant (3, 6), intercalée entre un substrat (2), dit "receveur", et une couche (14), dite "active", issue d'un substrat (1), dit "donneur", au moins l'une desdites couches d'isolant (3, 6) comprenant une couche (31, 61), dite "de piégeage", apte à retenir les espèces gazeuses éventuellement présentes au niveau des différentes interfaces de l'hétérostructure (5, 8) et à limiter la formation de défauts à la surface de la couche active (14) de ladite hétérostructure, ce procédé comprenant les étapes consistant à :
- former ou déposer au moins une couche d'isolant (3, 6) sur au moins l'un des deux substrats donneur (1) et receveur (2), ces deux substrats étant réalisés en matériau semi-conducteur,
- coller ledit substrat donneur (1) et ledit substrat receveur (2), par adhésion moléculaire, de façon que la ou les couche(s) d'isolant (3, 6) soi(ent) intercalée(s) entre eux et qu'il existe entre l'un des deux substrats (1, 2) et l'une des couches d'isolant (3, 6) ou entre les deux couches d'isolant (3, 6), une interface de collage (4, 7),
- retirer une partie (15), dite "reste", du substrat donneur (1), de façon à ne conserver que ladite couche active (14) et à obtenir ladite hétérostructure (5, 8), **caractérisé en ce qu'**avant le collage, on procède à la formation de ladite couche de piégeage (31, 61) en implantant au moins une catégorie d'espèces atomiques à l'intérieur d'au moins l'une des couches d'isolant (3, 6), cette catégorie d'espèces atomiques étant choisie de façon à être soit identique à l'une des espèces atomiques constituant la couche d'isolant (3, 6) dans laquelle ces espèces sont implantées, soit à appartenir à la même colonne du tableau de la classification périodique de Mendeleïev que l'une des espèces atomiques constituant la couche d'isolant (3, 6) dans laquelle elles sont implantées.

2. Procédé selon la revendication 1, **caractérisé en ce qu'**après la formation de la couche de piégeage (31, 61), on procède à une étape de recuit de la couche d'isolant (3, 6) contenant cette couche de piégeage, à une température d'au moins 350°C, pendant au moins 30 minutes.

3. Procédé selon la revendication 1 ou 2, **caractérisé en ce que** les paramètres de l'implantation sont choisis de façon à former ladite couche de piégeage (31, 61) à proximité de ladite interface de collage (4, 7).

4. Procédé selon la revendication 3, **caractérisé en ce que** la couche de piégeage (31, 61) est formée à une distance comprise entre 2 et 10 nanomètres de l'interface de collage (4, 7).

5. Procédé selon la revendication 1 ou 2, **caractérisé en ce que** les paramètres de l'implantation sont choisis de façon à former ladite couche de piégeage (31, 61) à proximité d'une interface de liaison (20, 60) entre la couche d'isolant (3, 6) et l'un ou l'autre des deux substrats (1, 2).

6. Procédé selon l'une des revendications précédentes, **caractérisé en ce que** ladite couche de piégeage (31, 61) est constituée d'une couche bidimensionnelle de nanocavités ou de nanoparticules.

7. Procédé selon l'une quelconque des revendications précédentes, **caractérisé en ce que** l'isolant (3, 6) est un oxyde.

8. Procédé selon l'une quelconque des revendications 1 à 6, **caractérisé en ce que** l'isolant (3, 6) est un nitrure.

9. Procédé selon la revendication 7, **caractérisé en ce que** l'isolant (3, 6) est du dioxyde de silicium (SiO₂) et **en ce que** les espèces implantées sont choisies parmi les atomes de silicium, de germanium et d'oxygène.

10. Procédé selon la revendication 9, **caractérisé en ce que** l'on implante des atomes de silicium avec une énergie d'implantation comprise entre 0,5 et 5 keV et une dose d'implantation comprise entre 5.10¹⁵ et 5.10¹⁶ Si⁺/cm².

11. Procédé selon la revendication 9, **caractérisé en ce que** l'on implante des atomes de germanium avec une énergie d'implantation comprise entre 0,7 et 10 keV et une dose d'implantation comprise entre 5.10¹⁵ et 1.10¹⁷ Ge⁺/cm².

12. Procédé selon la revendication 9, **caractérisé en ce que** l'on implante des atomes d'oxygène avec une énergie d'implantation comprise entre 0,5 et 3 keV et une dose d'implantation comprise entre 1.10¹⁵ et 1.10¹⁷ O⁺/cm².

13. Procédé selon la revendication 8, **caractérisé en ce que** l'isolant (3, 6) est du nitrure de silicium (Si₃N₄) et **en ce que** les espèces implantées sont choisies parmi les atomes de silicium, de germanium et d'azote.

14. Procédé selon la revendication 13, **caractérisé en ce que** l'on implante des atomes de silicium avec une énergie d'implantation comprise entre 0,5 et 5 keV et une dose d'implantation comprise entre 5.10¹⁵ et 5.10¹⁶ Si⁺/cm².

15. Procédé selon la revendication 13, **caractérisé en ce que** l'on implante des atomes de germanium avec une énergie d'implantation comprise entre 0,7 et 10 keV et une dose d'implantation comprise entre 5.10¹⁵ et 1.10¹⁷ Ge⁺/cm².

16. Procédé selon la revendication 13, **caractérisé en ce que** l'on implante des atomes d'azote avec une énergie d'implantation comprise entre 0,5et 3 keV et une dose d'implantation comprise entre 1.10¹⁵ et 1.10¹⁷N⁺/cm².

17. Procédé selon l'une quelconque des revendications précédentes, **caractérisé en ce que** le retrait de la partie arrière (15) est effectué par polissage mécanico-chimique.

18. Procédé selon l'une quelconque des revendications 1 à 16, **caractérisé en ce qu'**avant le collage, on forme une zone de fragilisation (13) à l'intérieur du substrat source (1), cette zone de fragilisation (13) délimitant la couche active (14), du reste (15) dudit substrat (1) destiné à être retiré.

19. Procédé selon la revendication 18, **caractérisé en ce que** la zone de fragilisation (13) est formée par implantation d'espèces atomiques.

20. Hétérostructure (5, 8) du type "semi-conducteur sur isolant", comprenant au moins une couche d'isolant (3, 6), intercalée entre un substrat (2), dit "receveur", en matériau semi-conducteur, et une couche (14), dite "active", en matériau semi-conducteur, **caractérisée en ce qu'**au moins l'une desdites couches d'isolant (3, 6) comprend une couche (31, 61) de piégeage constituée d'une couche bidimensionnelle de nanocavités ou de nanoparticules, cette couche de piégeage (31, 61) étant apte à retenir les espèces gazeuses éventuellement présentes au niveau des différentes interfaces de l'hétérostructure (5, 8) et à limiter la formation de défauts à la surface de la couche active (14) de ladite hétérostructure.

## Claims

1. A method of fabricating a "semiconductor on insulator" type heterostructure (5, 8) comprising at least one insulating layer (3, 6) interposed between a substrate (2) termed the "receiver" substrate and a layer (14) termed the "active" layer, derived from a substrate (1) termed the "donor" substrate, at least one of said insulating layers (3, 6) comprising a layer (31, 61) termed the "trapping layer", which can retain the gaseous species which may be present at the various interfaces of the heterostructure (5, 8) and limit the formation of defects on the surface of the active layer (14) of said heterostructure, said method comprising steps consisting in:
• forming or depositing at least one insulating layer (3, 6) on at least one of the two substrates, donor (1) and receiver (2), these two substrates being formed from semiconductor material ;
• bonding said donor substrate (1) and said receiver substrate (2) by molecular bonding such that the insulating layer or layers (3, 6) is (are) interposed between them and such that a bonding interface (4, 7) exists between one of the two substrates (1, 2) and one of the insulating layers (3, 6) or between the two insulating layers (3, 6);
• withdrawing a portion (15) of the donor substrate (1), termed the "remainder", to retain only said active layer (14) and to obtain said heterostructure (5, 8),
the method being **characterized in that** prior to bonding, said trapping layer (31, 61) is formed by implanting at least one category of atomic species in at least one of said insulating layers (3, 6), said atomic species category being selected so as to be either identical to one of the atomic species constituting said insulating layer (3, 6) in which these species are implanted, or to belong to the same column of the periodic table as one of the atomic species constituting the insulating layer (3, 6) in which they are implanted.

2. A method according to claim 1, **characterized in that** after forming the trapping layer (31, 61), a step of annealing the insulating layer (3, 6) containing said trapping layer is carried out at a temperature of at least 350°C for at least 30 minutes.

3. A method according to claim 1 or claim 2, **characterized in that** the implantation parameters are selected so as to form said trapping layer (31, 61) close to said bonding interface (4, 7).

4. A method according to claim 3, **characterized in that** the trapping layer (31, 61) is formed at a distance comprised between 2 nanometers to 10 nanometers from the bonding interface (4, 7).

5. A method according to claim 1 or claim 2, **characterized in that** the implantation parameters are selected so as to form said trapping layer (31, 61) close to a connection interface (20, 60) between the insulating layer (3, 6) and one of the two substrates (1, 2).

6. A method according to any preceding claim, **characterized in that** the trapping layer (31, 61) is constituted by a two-dimensional layer of nanocavities or nanoparticles.

7. A method according to any preceding claim, **characterized in that** the insulator (3, 6) is an oxide.

8. A method according to any one of claims 1 to 6, **characterized in that** the insulator (3, 6) is a nitride.

9. A method according to claim 7, **characterized in that** the insulator (3, 6) is silicon dioxide (SiO₂) and **in that** the implanted species are selected from silicon, germanium and oxygen atoms.

10. A method according to claim 9, **characterized in that** silicon atoms are implanted with an implantation energy in the range 0.5 keV to 5 keV with an implantation dose in the range 5 × 10¹⁵ to 5 × 10¹⁶ Si⁺/cm².

11. A method according to claim 9, **characterized in that** germanium atoms are implanted with an implantation energy in the range 0.7 keV to 10 keV with an implantation dose in the range 5 × 10¹⁵ to 1 × 10¹⁷ Ge⁺/cm².

12. A method according to claim 9, **characterized in that** oxygen atoms are implanted with an implantation energy in the range 0.5 keV to 3 keV with an implantation dose in the range 1 × 10¹⁵ to 1 × 10¹⁷ O⁺/cm².

13. A method according to claim 8, **characterized in that** the insulator (3, 6) is silicon nitride (Si₃N₄) and **in that** the implanted species are selected from silicon, germanium and nitrogen atoms.

14. A method according to claim 13, **characterized in that** silicon atoms are implanted with an implantation energy in the range 0.5 keV to 5 keV with an implantation dose in the range 5 × 10¹⁵ to 5 × 10¹⁶ Si⁺/cm².

15. A method according to claim 13, **characterized in that** germanium atoms are implanted with an implantation energy in the range 0.7 keV to 10 keV with an implantation dose in the range 5 × 10¹⁵ to 1 × 10¹⁷ Ge⁺/cm².

16. A method according to claim 13, **characterized in that** nitrogen atoms are implanted with an implantation energy in the range 0.5 keV to 3 keV with an implantation dose in the range 1 × 10¹⁵ to 1 × 10¹⁷ N⁺/cm².

17. A method according to any preceding claim, **characterized in that** the back portion (15) is withdrawn by chemical-mechanical polishing.

18. A method according to any one of claims 1 to 16, **characterized in that** prior to bonding, a zone of weakness (13) is formed in the source substrate (1), said zone of weakness (13) defining the active layer (14) from the remainder (15) of said substrate (1) destined to be withdrawn.

19. A method according to claim 18, **characterized in that** the zone of weakness (13) is formed by atomic species implantation.

20. A "semiconductor on insulator" type heterostructure (5, 8) comprising at least one insulating layer (3, 6) interposed between a substrate (2) termed the "receiver" substrate formed from semiconductor material, and a layer (14) termed the "active" layer formed from semiconductor material, **characterized in that** at least one of said insulating layers (3, 6) comprises a trapping layer (31, 61) constituted by a two-dimensional layer of nanocavities or nanoparticles, this trapping layer (31, 61) being able to retain the gaseous species which may be present at the various interfaces of the heterostructure (5, 8) and to limit the formation of defects on the surface of the active layer (14) of said heterostructure.

## Patentansprüche

1. Verfahren zur Herstellung einer Heterostruktur (5,8) des Typs "Halbleiter auf Isolation", die mindestens eine Isolationsschicht (3,6) aufweist, die zwischen einem sogenannten "Rezeptor"-Substrat (2) und einer sogenannten "aktiven" Schicht (14) angeordnet ist, die aus einem sogenannten "Donator"-Substrat (1) hervorgeht, wobei mindestens eine der Isolationsschichten (3,6) eine sogenannte "Einfang"schicht (31,61) aufweist, die Gasteilchen, die möglicherweise im Bereich verschiedener Grenzflächen der Heterostruktur (5,8) vorhanden sind, zurückhalten kann und die Bildung von Fehlstellen an der Oberfläche der aktiven Schicht (14) der Heterostruktur begrenzen kann, wobei das Verfahren die folgenden Schritte aufweist:
- Bildung oder Abscheidung mindestens einer Isolationsschicht (3,6) auf dem Donator-Substrat (1) und/oder dem Rezeptor-Substrat (2), wobei diese beiden Substrate aus einem Halbleitermaterial bestehen,
- Zusammenkleben des Donator-Substrats (1) und des Rezeptor-Substrats (2) mittels molekularer Adhäsion, so dass die Isolationsschicht(en) (3,6) zwischen ihnen angeordnet ist/sind und es zwischen einem der beiden Substrate (1,2) und einer der Isolationsschichten (3,6) oder zwischen den zwei Isolationsschichten (3,6) eine Klebfläche (4,7) gibt,
- Entfernen eines Teils (15), genannt "Rest", des Donator-Substrats (1), um nur die aktive Schicht (14) zu behalten und die Heterostruktur (5,8) zu erzielen,
**dadurch gekennzeichnet, dass** vor dem Kleben die Bildung der Einfangschicht (31,61) erfolgt, indem mindestens eine Sorte von Atomen in das Innere mindestens einer der Isolationsschichten (3,6) implantiert wird, wobei die Atomsorte so ausgewählt wird, dass sie entweder identisch ist mit einer der Atomsorten, aus denen die Isolationsschicht (3,6) besteht, in welche diese Atome implantiert werden, oder dass sie in der gleichen Spalte des Periodensystems der Elemente steht wie eine der Atomsorten, aus denen die Isolationsschicht (3,6) besteht, in welche sie implantiert werden.

2. Verfahren nach Anspruch 1, **dadurch gekennzeichnet, dass** nach der Bildung der Einfangschicht (31,61) ein Schritt zum Glühen der diese Einfangschicht enthaltenden Isolationsschicht (3,6) auf eine Temperatur von mindestens 350°C während mindestens 30 Minuten durchgeführt wird.

3. Verfahren nach Anspruch 1 oder 2, **dadurch gekennzeichnet, dass** die Parameter der Implantation so gewählt werden, dass die Einfangschicht (31,61) in der Nähe der Klebfläche (4,7) gebildet wird.

4. Verfahren nach Anspruch 3, **dadurch gekennzeichnet, dass** die Einfangschicht (31,61) in einem Abstand, der zwischen 2 und 10 Nanometer beträgt, von der Klebfläche (4,7) gebildet wird.

5. Verfahren nach Anspruch 1 oder 2, **dadurch gekennzeichnet, dass** die Implantationsparameter so gewählt werden, dass die Einfangschicht (31,61) in der Nähe einer Verbindungsschicht (20,60) zwischen der Isolationsschicht (3,6) und dem einem oder dem anderen der beiden Substrate (1,2) gebildet wird.

6. Verfahren nach einem der vorstehenden Ansprüche, **dadurch gekennzeichnet, dass** die Einfangschicht (31,61) aus einer zweidimensionalen Schicht von Nanohohlräumen oder Nanopartikeln besteht.

7. Verfahren nach einem der vorstehenden Ansprüche, **dadurch gekennzeichnet, dass** die Isolation (3,6) ein Oxid ist.

8. Verfahren nach einem der Ansprüche 1 bis 6, **dadurch gekennzeichnet, dass** die Isolation (3,6) ein Nitrid ist.

9. Verfahren nach Anspruch 7, **dadurch gekennzeichnet, dass** die Isolation (3,6) Siliziumdioxid (SiO₂) ist, und dadurch, dass die implantierten Teilchen ausgewählt werden aus: Atome von Silizium, Germanium und Sauerstoff.

10. Verfahren nach Anspruch 9, **dadurch gekennzeichnet, dass** Siliziumatome mit einer Implantationsenergie zwischen 0,5 und 5keV und einer Implantationsdosis zwischen 5x10¹⁵ und 5x10¹⁶ Si⁺/cm² implantiert werden.

11. Verfahren nach Anspruch 9, **dadurch gekennzeichnet, dass** Germaniumatome mit einer Implantationsenergie zwischen 0,7 und 10keV und einer Implantationsdosis zwischen 5x10¹⁵ und 1x10¹⁷ Ge⁺/cm² implantiert werden.

12. Verfahren nach Anspruch 9, **dadurch gekennzeichnet, dass** Sauerstoffatome mit einer Implantationsenergie zwischen 0,5 und 3keV und einer Implantationsdosis zwischen 1x10¹⁵ und 1x10¹⁷ O⁺/cm² implantiert werden.

13. Verfahren nach Anspruch 8, **dadurch gekennzeichnet, dass** die Isolation Siliziumnitrid (Si₃N₄) ist, und dadurch, dass die implantierten Teilchen ausgewählt werden aus: Atome von Silizium, Germanium und Stickstoff.

14. Verfahren nach Anspruch 13, **dadurch gekennzeichnet, dass** Siliziumatome mit einer Implantationsenergie zwischen 0,5 und 5 keV und einer Implantationsdosis zwischen 5x10¹⁵ und 5x10¹⁶ Si⁺/cm² implantiert werden.

15. Verfahren nach Anspruch 13, **dadurch gekennzeichnet, dass** Germaniumatome mit einer Implantationsenergie zwischen 0,7 und 10keV und einer Implantationsdosis zwischen 5x10¹⁵ und 1x10¹⁷ Ge⁺/cm² implantiert werden.

16. Verfahren nach Anspruch 13, **dadurch gekennzeichnet, dass** Stickstoffatome mit einer Implantationsenergie zwischen 0,5 und 3keV und einer Implantationsdosis zwischen 1x10¹⁵ und 1x10¹⁷ N⁺/cm² implantiert werden.

17. Verfahren nach einem der vorstehenden Ansprüche, **dadurch gekennzeichnet, dass** das Entfernen des hinteren Teils (15) durch ein mechanisch-chemisches Polieren erfolgt.

18. Verfahren nach einem der Ansprüche 1 bis 16, **dadurch gekennzeichnet, dass** vor dem Kleben eine Versprödungszone (13) im Innern des Quellensubstrats (1) gebildet wird, wobei diese Versprödungszone (13) die aktive Schicht (14) vom zu entfernenden Rest (15) des Substrats (1) trennt.

19. Verfahren nach Anspruch 18, **dadurch gekennzeichnet, dass** die Versprödungszone (13) durch Implantation von Atomen gebildet wird.

20. Heterostruktur (5,8) des Typs "Halbleiter auf Isolation" mit mindestens einer Isolationsschicht (3,6), die zwischen einem sogenannten "Rezeptor"-Substrat (2) aus Halbleitermaterial und einer sogenannten "aktiven" Schicht (14) aus Halbleitermaterial angeordnet ist,
**dadurch gekennzeichnet, dass** mindestens eine der Isolationsschichten (3,6) eine Einfangschicht (31,61) aufweist, die aus einer zweidimensionalen Schicht von Nanohohlräumen oder Nanopartikeln besteht, wobei diese Einfangschicht (31,61) Gasteilchen, die möglicherweise im Bereich verschiedener Grenzflächen der Heterostruktur (5,8) vorhanden sind, zurückhalten kann und die Bildung von Fehlstellen an der Oberfläche der aktiven Schicht (14) der Heterostruktur begrenzen kann.
